# EUROPÄISCHE PATENTSCHRIFT

(11) **EP 2 016 777 B1**
(45) Veröffentlichungstag und Bekanntmachung des Hinweises auf die Patenterteilung: **27.07.2011**
(21) Anmeldenummer: 07703259.7
(22) Anmeldetag: 05.02.2007
(51) Int. Cl.: H04Q 1/02

(54) **SCHALTERANORDNUNG FÜR KOMMUNIKATIONS-DATENSTRÖME**
SWITCH ARRANGEMENT FOR COMMUNICATION DATA STREAMS
COMMUTATEUR POUR DES FLUX DE DONNÉES DE COMMUNICATION

(30) Priorität: 09.05.2006 DE 202006007475 U; 26.07.2006 DE 102006035240
(43) Veröffentlichungstag der Anmeldung: 21.01.2009
(73) Patentinhaber: ICOS Gesellschaft für industrielle Communications-Systeme mbH, 40549 Düsseldorf (DE)
(72) Erfinder: STÄCKER, Joachim, 40789 Monheim am Rhein (DE); HILGERS, Werner, 41379 Brüggen (DE)
(74) Vertreter: GROSSE SCHUMACHER KNAUER VON HIRSCHHAUSEN
(86) Internationale Anmeldenummer: PCT/EP2007/000949
(87) Internationale Veröffentlichungsnummer: WO 2007/128357

(56) Entgegenhaltungen:
- WO-A-98/59482
- US-A- 4 910 770
- US-A- 6 078 661
- US-B1- 6 510 226

## Beschreibung

### TECHNISCHES GEBIET

Die Erfindung betrifft eine Schalteranordnung für Kommunikations-Datenströme gemäß dem Oberbegriff von Anspruch 1.

### TECHNISCHER HINTERGRUND

Schalter oder Schalteranordnungen für Kommunikations-Datenströme beinhalten in der Regel ein Gehäuse mit einem in einer Außenwand angeordneten Front-Paneel zum Herstellen von Datenverbindungen mit oder ohne Kabel. Das Gehäuse schützt eine oder mehrere Platinen, auf der neben einer Vielzahl elektronischer Bauteile vor allem mehrere oder auch nur ein Prozessor für das Schalten der Kommunikations-Datenströme untergebracht ist. Die erhebliche Wärmeentwicklung des Prozessors wird über aktive und/oder passive Kühleinrichtungen abgeleitet. Für die Nutzung unter rauen Umweltbedingungen wie sie unter anderem in militärischen Einrichtungen vorkommen, sind die bekannten Schalteranordnungen unzureichend.

Die US 6,078,661 A zeigt eine Schalteranordnung für Kommunikationsdatenströme, bei der EDV-Ein- und Ausgangsanschlüsse direkt auf einer Platine innerhalb eines Gehäuses angeordnet sind. Beim Öffnen des Gehäusedeckels wird die gesamte Platine mit Eingangsanschlüssen und Ausganganschlüssen frei zugänglich. Auch wenn man lediglich den Kundenzutrittsdeckel öffnet, sind die direkt auf der Platine angeordneten Ausgangsanschlüsse zugänglich.

### DARSTELLUNG DER ERFINDUNG

Der Erfindung liegt die Aufgabe zugrunde, eine gattungsgemäße Schalteranordnung, ein Schaltermodul sowie eine Kühlanordnung hierfür zu schaffen, die sie für die rauen Einsatzbedingungen, wie sie bei Rohstoff-explorations- oder Gewinnungsanlagen, bei militärischen Anwendungen, in mobilen Einsatzgeräten und dergleichen auftreten, funktionssicher betrieben werden können.

Zur Lösung dieser Aufgabe wird eine Schalteranordnung mit den Merkmalen des Anspruchs 1 vorgeschlagen. Danach beruht die Erfindung auf dem Grundgedanken bei einer gattungsgemäße Schalteranordnung, bei der die äußeren Datenleitungen direkt oder indirekt an die EDV-Ein- und Ausgangsanschlüsse der Platinen angeschlossen werden können, die Gehäusefront in ein inneres Frontpanel und ein äußeres Frontpanel zu unterteilen. Dadurch wird es möglich, die Ein- und Ausgangsstecker der äußeren Datenleitungen in das Gehäuseinnere zu verlegen, also in einen gegen Umwelteinflüsse geschützten Raum. Bei einer derartigen Aufteilung der Gehäusefront in ein inneres und ein äußeres Frontpanel kann das innere Frontpanel Aussparungen für direkte Kabelanschlüsse zu den Platinen bildende Ein- und Ausgangsanschlüsse aufweisen, während das äußere Frontpanel auf die Querschnitte der äußeren Datenleitungen reduzierbare Aussparungen aufweist. Dabei bedeutet "auf die Querschnitte der äußeren Datenleitungen reduzierbare Aussparungen" im Sinne der Erfindung, dass die Aussparungen derart gestaltet sind, dass sie eine ausreichende Größe oder Anordnung bzw. Gestaltung aufweisen, um das Einführen der äußeren Datenleitungen zwischen das äußere und das innere Frontpanel und Verbinden mit den Ein- und Ausgangsanschlüssen am inneren Frontpanel zu ermöglichen und dass der freigelassene Querschnitt im äußeren Frontpanel auf den Querschnitt der äußeren Datenleitungen reduziert wird oder ist. Dies kann unter Anderem durch bewegbare Blenden oder dadurch geschehen, dass das äuβere Frontpanel zweiteilig gestaltet ist und ein gehäusefestes Gehäusefrontteil und ein, z. B. mit einem Deckel bewegbares oder als Deckel ausgebildetes Deckel-Frontteil aufweist, zwischen denen im Verschlussfalle nur noch die Durchlassquerschnitte für die äußeren Datenleitungen frei bleiben. Schalteranordnungen mit den Merkmalen des Anspruchs 1 sind auch dann von eigenständiger erfinderischer Bedeutung, wenn nur Datenempfang oder nur Datenversendung stattfindet. Derartige Schalteranordnungen können nun auf sehr verschiedene Weise realisiert und noch weiter verbessert werden:

Die Ein- und Ausgangsanschlüsse für den Datenempfang und/oder die Datenversendung über äußere Datenleitungen sind bevorzugt direkt an der mindestens einen Platine der Schalteranordnung angeordnet und die Befestigung ist entsprechend empfindlich gegen mechanische Belastungen beim Anschluss der äußeren Datenleitung. Diese Belastungen können durch weiter unten beschriebene Maßnahmen neutralisiert werden. Es ist aber auch möglich, die Ein- und Ausgangsanschlüsse indirekt an der mindestens einen Platine vorzusehen, d.h. im Wege einer mechanischen Entkopplung unter Verwendung geeigneter, insbesondere flexibler, elektrischer Verbindungsleitungen. Die Ein- und Ausgangsanschlüsse sind bevorzugt standardisierte Bauteile, wie sie in Innenräumen für EDV-Anwendungen verwendet werden, also mechanisch relativ unrobust und gegen Staub, Feuchtigkeit und Erschütterungen nicht geschützt. Sie haben den Vorteil große Anwendungsverbreitung und normierter Ausführung sowie einfacher Handhabung. Die Unterteilung der Gehäusefront in ein inneres Frontpanel und ein äuβeres Frontpanel erlaubt es, die äußeren Datenleitungen direkt an solche Ein- und Ausgangsanschlüsse an dem inneren Frontpanel anzuschließen und die übrigen Schutzfunktionen an dem äußeren Frontpanel und/oder dem Zwischenraum zwischen den beiden Frontpanelen vorzusehen, ohne dass speziellere Steckverbindungen erforderlich sind.

Wenn das äußere Frontpanel auf die Querschnitte der äußeren Datenleitungen reduzierbare oder reduzierte zweite Aussparungen aufweist, kann dadurch ein von der Umgebungsatmosphäre im wesentlichen abgeschlossener Raum zwischen dem inneren und dem äußeren Frontpanel geschaffen werden, der unter anderem auch eine Entkopplung äußerer mechanischer Einflüsse auf die äußeren Datenleitungen von den Anschlussverbindungen an den Platinen ermöglicht. Um die Schutzwirkung der Aussparungen im äußeren Frontpanel zu verbessern, sind Verschließ- und/oder Dichtkörper in diese (zweiten Aussparungen) eingesetzt oder einsetzbar.

Bei der Verwendung elastischer Dichtkörper in den Aussparungen des äußeren Frontpanels kann das Anschließen oder Entfernen von Datenleitungen schwierig zu bewerkstelligen sein, wenn die Schalteranorndung an eine Mehrzahl von Datenleitungen anzuschließen ist. Deshalb wird vorgeschlagen, dass die elastischen Dichtungskörper zunächst in das äußere Frontpanel eingesetzt und zur nachträglichen Aufnahme der äuβeren Datenleitungen vorgesehen sind, also beim Einbau der Datenleitungen ihren schon eingenommen Platz in dem äußeren Frontpanel beibehalten. Bei bereits in das äußere Frontpanel eingesetzten Dichtkörpern ist es von besonderem Vorteil, wenn sie unverdrehbar in entsprechenden Aufnahmen des äußeren Frontpanels ruhen. Dies fördert ordnungsgemäßes Dichten gegenüber der äußeren Datenleitung sowie korrektes und dichtes Verschließen des Frontpanels. Um das Schließen eines insbesondere zweiteiligen äußeren Frontpanels nach dem Einbau der äußeren Datenleitungen wesentlich zu vereinfachen, sind die Dichtkörper mit zumindest einem Führungselement versehen, welches ein gleichzeitiges Aufschieben eines Deckelfrontteils auf sämtliche Dichtungskörper im äußeren Frontpanel gestattet. Auf diese Weise ergibt sich eine selbsttätige Zentrierung welche den im festen äußeren Frontpanelteil ruhenden Dichtkörper auf einfache Weise mit dem beweglichen Teil des Frontpanels in eine dort vorgesehene Aufnahme einführen lässt, in dem das bewegbare Frontpanelteil gleichzeitig auf alle ruhenden Dichtkörper aufgeschoben wird.

Auf den äußeren Datenleitungen lasten unterschiedliche Kräfte aufgrund von Einbaupositionen und mechanischen Belastungen im Betrieb. Damit diese nicht auf die Ein- und Ausgangsanschlüsse der Schalteranordnung übertragen werden, werden bevorzugt Zugentlastungen und/oder Richtungsgebungselemente für die äußeren Datenleitungen vorgesehen. Diese können vor und/oder hinter dem äußeren Frontpanel und vorzugsweise auch unter einem Deckel angeordnet sein.

Wenn hingegen nur sehr kleine Schwenkwinkel realisierbar sind, wird bevorzugt ein Deckelfrontteil verwendet, dass sich nach leichtem Verschwenken ganz fortnehmen lässt.

Das Deckelfrontteil ist gegenüber dem Gehäuse vorzugsweise umlaufend anliegend angeordnet, insbesondere in gedichteter Weise. Gleichzeitig kann die Anschließbarkeit der äußeren Datenleitungen und deren Einbau in das Frontpanel erleichtert werden, wenn das Deckelfrontteil gegenüber dem Gehäuse über seitliche Schrägauflagen in seiner Randzone verfügt. Ein Abgleiten über solche Schrägflächen lässt sich durch an sich bekannte Anschläge (auch als Knacken bekannt) verhindern.

Um die Verriegelung eines Deckelfrontteils gegenüber dem Gehäuse entgegen elastischen Spannungen von Dichtkörpern auch unter rauen Einsatzbedingungenund/oder Vibrationen sicher zu gestalten, werden Deckelverriegelungselemente mit federnd selbsthaltender Verriegelungsstellung zusätzlich mit einem Formschlussverrigelungselement zum Sperren der federnden Selbsthaltung in der Verschließstellung gesichert.

Um negative Einflüsse elektromagnetischer oder anderer Strahlungen auf die Schalteranordnung bzw. aus der Schalteranordnung auf die Umgebung zu vermeiden, können die in dem inneren Frontpanel vorgesehenen Durchbrüche für Steckverbindungsanschlüsse zu der mindestens einen Platine dadurch lecksicherer gemacht werden, dass ein flächiges Strahlungsschutzorgan zwischen der mindestens einen Platine und dem inneren Frontpanel eingefügt wird. Die in diesem Strahlungsschutzorgan vorgesehenen Durchbrüche können sehr präzise auf z.B. Steckverbindungsabmessungen angepasst werden, so dass die Gestaltung des inneren Frontpanels dem Bedarf besser angepasst werden kann. Federnde Rastelemente, die seitlich des Strahlungsschutzorgans beidseitig hervorstehen, können in geeigneter Weise an der mindestens einen Platine oder anderen konstruktiven Elementen der Schalteranordnung verrastet werden, so dass lediglich die in dem Strahlungsschutzorgan vorgesehene Verbindungsdurchbrüche frei bleiben und die übrigen Flächenbereiche strahlungsgeschützt sind. Durch Rastelemente auf der mindestens einen Platine gegenüberliegenden Seite des Strahlungsschutzorgans, kann die so hergestellte modulartige Einheit in das Gehäuse der Schalteranordnung eingesetzt und dort federnd und/oder rastend an geeigneten Konstruktionselementen des Gehäuses und insbesondere des inneren Frontpanels anliegen. Eine derartige Strahlungsschutzanomdung ist von eigenständiger erfinderischer Bedeutung.

Die Verwendungsbefähigung der Schalteranordnung unter rauen Einsatzbedingungen wird weiter verbessert, wenn der Kühler des mindestens einen Prozessors als Rippenkühler auf einer Gehäuseteilaußenfläche vorzusehen ist und mittels eines Wärmeableiters, wie einer so genannten Heatpipe, im Gehäuseinneren mit dem mindestens einen Prozessor körperlich wärmeleitend kontaktiert ist. Auf diese Weise werden die Wärmeabfuhrmöglichkeiten der Umgebungsatmosphäre ohne Schaden für den Prozessor nutzbar gemacht. Eine etwa erwünschte aktive Konvektionskühlung kann vom Gehäuseinneren auf das Gehäuseäußere verlagert werden und mit Gebläsen geschehen, die den gegebenen Umweltbedingungen besonders gut standhalten.

Wenn das den Rippenkühler auf seiner Außenfläche tragende oder bildende Gehäuseteil unter gegenseitiger Abstandshaltung mit der mindestens einen Platine, die den mindestens einen Prozessor für die Schaltung der Kommunikations-Datenströme trägt, starr verbunden ist, wird damit eine kompakte und mechanisch äußerst stabile modulare Einheit geschaffen, die einfach handhabbar und über flexible Datenkabel mit einem Gehäuse bzw. einer Gehäusefront für die Daten Ein- und Ausgänge verbindbar ist. Eine solche modulare Anordnung ist auch unabhängig von den kennzeichnenden Merkmalen des Anspruch 1 von eigenständig erfinderischer Bedeutung. Wenn bei einer solchen modularen Anordnung die eine Seitenfläche von dem Rippenkühler und die andere Seitenfläche von der Platinenunterseite gebildet werden, entsteht eine Sandwich-Konstruktion mit einem sehr effektiven mechanischen Schutz durch die großen Außenflächen.

Als besonders vorteilhaft hat sich erwiesen, wenn der Rippenkühler im Wesentlichen die gesamte Außenfläche einer Gehäuseseite, der Außenwand er bildet oder auf der Außenwand er aufgesetzt ist, einnimmt. Dies ist sowohl hinsichtlich der verfügbaren Kühlleistung als auch hinsichtlich des mechanischen Schutzes des mindestens einen Prozessors und der mindestens einen Platine sowie für die Festigkeit des Moduls und des Gehäuses insgesamt vorteilhaft. Wenn ein derartiger vollflächig die Gehäuseseite bzw. Modulseite bildender Rippenkühler quer zu den Rippen mit Abstand voneinander vorgesehene (Quer-) Fräsungen aufweist, wird die Anordnung von bestimmten Einbaulagen, z.B. in einem Fahrzeug noch unabhängiger. Dadurch kann die Anordnung in einer dem Platzangebot besonders gut entsprechenden Position eingebaut werden, ohne dass darunter ein äußerer konvektiver Kühlstrom behindert wird.

Wenn mehr als ein Prozessor vorgesehen ist, erweist es sich als wärmetechnisch sowie mechanisch vorteilhaft, wenn ein gemeinsames Wärmeausgleichselement, das die Prozessoren wärmetechnisch miteinander verbindet vorgesehen wird und der oder die Wärmeableiter zwischen dem Wärmeausgleichselement und dem Rippenkühler auf der Gehäuseaußenwand angeordnet wird/werden. Auf diese Weise entfällt die räumliche direkte Zuordnung zwischen den einzelnem Prozessoren und dem Rippenkühler. Vielmehr kann der mindestens eine Wärmeableiter an einer wärmetechnisch und mechanisch besonders günstigen Stelle angeordnet werden. Insbesondere kann die Zahl der Wärmeabieiter unabhängig von der Zahl der Prozessoren gewählt werden, um so eine bestmögliche Wärmeableitung zu gewährleisten.

Wenn die mindestens eine den mindestens einen Prozessor tragende Platine als Sandwich verstärkte Anordnung gestaltet ist, wird dadurch der mechanische Schutz der Anordnung verbessert. Zu diesem Zweck wird bevorzugt eine mechanisch stabile Platte, insbesondere eine Leichtbauplatte, wie eine Platte aus Kohlenfaserwerkstoff, über Distanzelemente am geeigneten Rückseitenbereich der Platine mit der Platine zu einer Sandwicheinheit verbunden. Die Distanzmittel können beidseitig selbstklebende Flächenelemente sein, die nach Art eines Patch-Feldes dort auf der Platinenrückseite angebracht werden, wo ein Zugriff auf Bauteile der Platine nicht erforderlich ist und/oder die Platine frei von Erhebungen, wie Lötpunkten ist. Ein Sandwich Aufbau der Platine ist auch unabhängig von den kennzeichnenden Merkmalen des Anspruchs 1 von eigenständiger erfinderischer Bedeutung.

Durch die erfindungsgemäße Kühlanordnung wird eine universelle Möglichkeit geschaffen, an beliebiger Stelle vorgesehene zu kühlende Prozessoren mit Distanz zu einer als Rippenkühler ausgebildeten Wand anzuordnen und damit einen gut kühlbaren Schutzraum für elektronische Bauteile bei sehr effizienter Prozessorenkühlung zu schaffen.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, sodass die in dem Anwendungsgebiet bekannten Auswahlkriterien uneingeschränkt Anwendung finden können

Weitere Einzelheiten, Merkmale und Vorteile des Gegenstandes der Erfindung ergeben sich aus den Unteransprüchen, sowie aus der nachfolgenden Beschreibung der zugehörigen Zeichnung und Tabelle, in der - beispielhaft - ein Ausführungsbeispiel einer Schalteranordnung dargestellt ist.

### KURZE BESCHREIBUNG DER FIGUREN

- Fig. 1A/B: eine erste Schalteranordnung in perspektivischer Darstellung mit offe- nem (Fig. 1 A) und geschlossenem (Fig. 1 B) Deckel;
- Fig. 2: eine weitere Schalteranorndung in perspektivischer Darstellung mit leicht geöffnetem Deckelteil (ausschnittsweise);
- Fig. 3A-C: für die Schalteranorndung nach Fig. 2 verschiedene Dichtkörper für das äußere Frontpanel in perspektivischer Darstellung;
- Fig. 4: für Schalteranordnungen nach Figuren 1A/B, 2 und 3 ein Strahlungs- schutzorgan sowie;
- Fig. 5: von der Schalteranordnung nach Fig. 2 bis 4 eine perspektivische Explosi- onsdarstellung mit Schaltermodul, Strahlungsschutzorgan und Gehäuse;
- Fig.6A: eine Schalteranordnung als modulares Bauteil in einer Seitensicht;
- Fig. 6B: dieselbe Schalteranordnung in (Schnittdarstellung Schnitt A-A gem. Fig. 6A);
- Fig. 7A: von der Schalteranordnung nach Fig. 6A/B die Kühlanordnung (mit Pro- zessoren) in Seitenansicht wie in Fig. 6A;
- Fig. 7B: dieselbe Kühlanordnung in um 90° gedrehter Seitenansicht;
- Fig. 8A: von der Schalteranordnung nach Fig. 6A/B eine Ansicht von unten;

- Fig. 8B: von der Schalteranordnung gem. Fig. 8A eine Schnittdarstellung (Schnitt entlang der Linie BB gem. Fig. 8A);
- Fig. 8C: von der Schalteranordnung nach Fig. 8B eine vergrößerte Darstellung des Details C;
- Fig. 9A-9C: von einer alternativen Schalteranordnung eine Seitenansicht (Fig. 9A), eine Draufsicht (Fig. 9B) und eine Frontansicht (Fig. 9C); sowie
- Fig. 10: dieselbe Schalteranordnung mit einer anderen Gerätefront in der Dar- stellung entsprechend Fig. 9C;

### DETAILLIERTE FIGURENBESCHREIBUNG

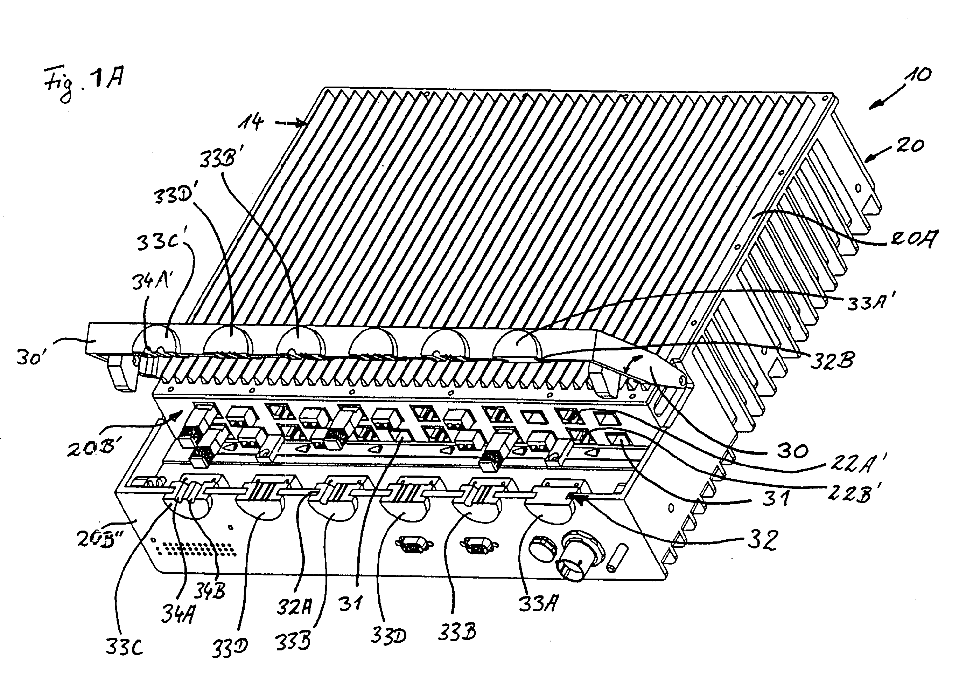

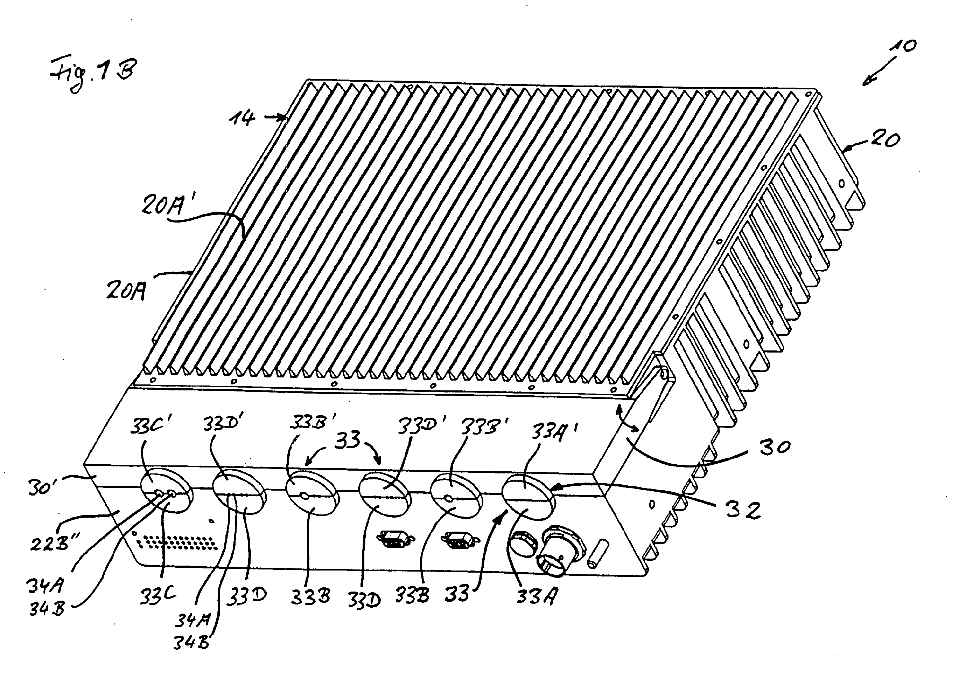

Fig. 1A/B zeigt eine Ein- und Ausgangsanschlusstechnik für Datenempfang und Datenversendung ohne Ein- und Ausgangsstecker an einer Gehäusefront 20B durch Integration der Anschlusstechnik in ein Gehäuse 20.

Die Gehäusefront 20B und ein Rippenkühler 14 werden so gestaltet, dass die äußeren Datenleitungen direkt an Ein- und Ausgangsanschlüsse 22A', 22B' einer Platine 16, 16' angeschlossen werden können.

Um dies zu erreichen, wird in dem dargestellten und insoweit bevorzugten Ausführungsbeispiel der deckelseitige Rippenkühler 14 um einen Betrag von ca. 50 mm bezüglich der Gesamtdeckelfläche gekürzt. Der gekürzte Teil wird durch einen, eine Gehäuseteil-Außenfläche mit bildenden Deckel 30 gebildet, der damit quasi den Teil des vorderen, oberen Gehäuses 20 darstellt.

Die Gehäusefront (Frontpanel 20B) wird unterteilt in ein inneres Frontpanel 20B' und ein äußeres Frontpanel 20B". Das innere Frontpanel 20B' beinhaltet die ersten Aussparungen 31 für die Ein- und Ausgangsanschlüsse 22A', 22B' der im Gehäuseinneren befindlichen Platine 16,16', so dass die Ein- und Ausgangsanschlüsse der Platine 16,16' direkt zugänglich durch entsprechende Anordnung der Platine 16, 16' im Gehäuseinneren sind.

Das äußere Frontpanel 22B" und der Deckel 30 erhalten 6 gleiche, halbkreisförmige paarweise zugeordnete zweite Aussparungen 32 bestehend aus Teilaussparungen 32A, 32B. In diese Aussparungen (Durchbrüche) können Verschließkörper 33 eingesetzt werden. Hierzu sind in der dargestellten insoweit bevorzugten Ausführungsform paarweise einander zugeordnete halbkreisförmige Verschließkörper 33A, 33A' bis 33D, 33D' unterschiedlicher Ausprägung eingesetzt (nachfolgend als Dichtkörper bezeichnet). Diese dienen entweder dazu, die Aussparungen 32 komplett zu schließen, oder Datenleitungen eines bestimmten Querschnitts aufzunehmen. In der Zeichnung bedeuten: 33A = komplett schließen, 33B = Aufnahme von 1 Kupferdatenleitung und 1 Lichtwellendatenleitung 33C = Aufnahme von 2 Kupferdatenleitungen, 33D = Aufnahme von 2 Lichtwellendatenleitungen (LWL). Mit diesen Kombinationsmöglichkeiten sind alle möglichen Anschlüsse an die 12 Ein- und Ausgangsanschlüsse 22A', 22B' der Platine 16, 16' durchführbar. Das Material der Dichtkörper ist so hinsichtlich Festigkeit und Elastizität ausgeprägt, dass bei geschlossenem Deckel 30 immer die Schutzart IP 65 für die Übergänge zwischen Dichtkörper 33 und dem äußeren Frontpanel 22B" des Gehäuses 20 bzw. Deckels 30 und zwischen Dichtkörper und Datenleitungen gegeben ist.

Falls erforderlich können Zugentlastungen durch Kabelschellen und Schirmanbindungen z.B. durch Berilliumfedem in dem Gehäuseteil unterhalb des Deckels angebracht werden.

Der Verschlussmechanismus des Deckels entspricht den mechanischen Anforderungen hinsichtlich Schock, Vibration und Schutzart.

Vorteile dieser Ausführung: Es entfallen die Zwischenverbindungen zwischen den Einund Ausgangsanschlüssen 22A, 22B der Platine 16, 16' und den Steckern an der Gehäusefront 20B.

Es entfallen alle Datenein- und Ausgangsstecker an der Gehäusefront 20B.

Die äußeren Datenleitungen können mit ihren Standardanschlüssen (z.B. für Innenbereiche) direkt an die Ein- und Ausgangsanschlüsse 22A', 22B' angeschlossen werden. Zugentlastung und Schirmanbindung erfolgen durch entsprechende konstruktive Maßnahmen im Gehäuse.

Eine flexible Nutzung der Ein- und Ausgangsanschlüsse der Platine 16, 16' ist ohne Gehäuseänderung (Frontpanel 20B) nur durch Einsatz eines anderen entsprechenden Dichtkörperpaares möglich.

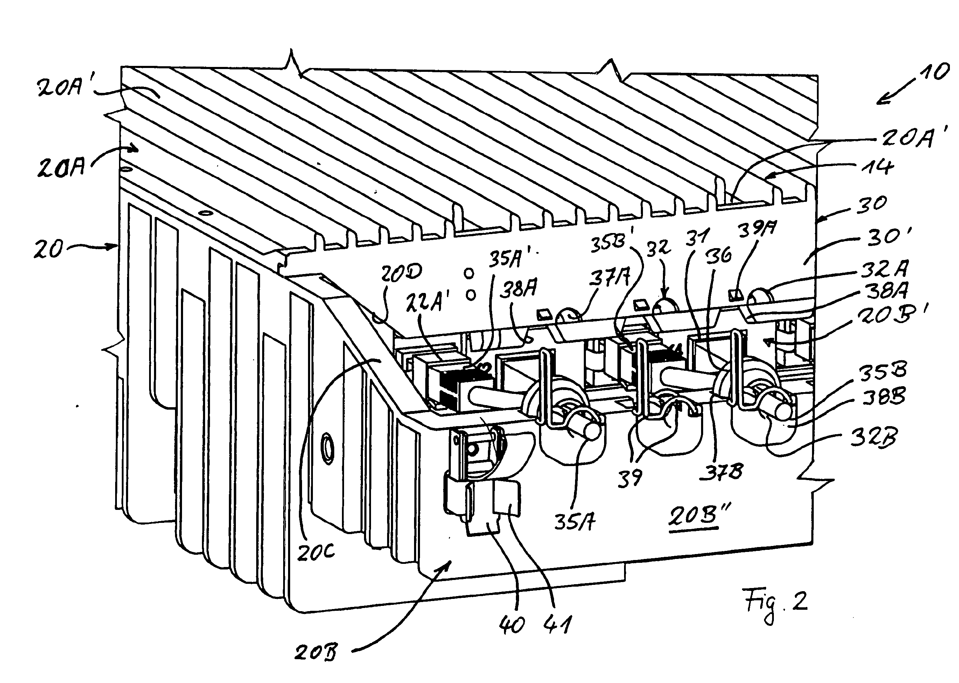

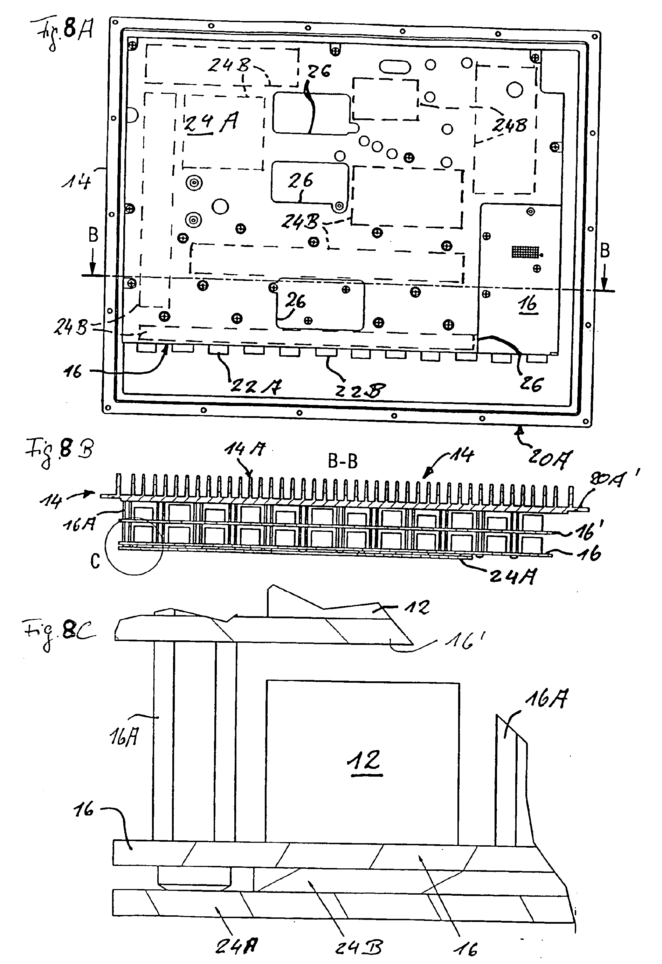

Figuren 2 bis 5 zeigen eine Alternative zu der Ausführungsform einer Schalteranordnung nach Figuren 1A/B. Auch bei diesem Ausführungsbeispiel ist ein, bevorzugt als Druckgussteil hergestellt und teilweise außen verripptes, Gehäuse 20 vorgesehen, dessen Oberseite deckelartig als Rippenkühler 14 ausgebildet ist und Teil eines Schaltermoduls samt zugehöriger Platinen und elektrischer Bauelemente ist. Dieser Deckel ist mit dem Gehäuse verschraubbar und über ein so genanntes Bogen- oder Steckscharnier mit einem fortnehmbaren leicht verschwenkbaren Deckel 30 verbindbar, der in seinem Frontteil 30' Teilaussparungen 32A aufweist, die mit Teilaussparungen 32B am Rande des feststehenden äußeren Frontpanels 20B" des Gehäuses 20 komplementär korrespondiert, um mit ausreichendem Spiel oder elastischer Anlage äußere Datenleitungen 35A, 35B an ihrem Umfang umfassend aufzunehmen. - Die zweiten (paarweise ausgestalteten) Aussparungen 32A, 32B sind mit inneren Aufnahmen derart versehen, dass darin je ein Dichtkörper 36 einsetzbar ist, um sowohl zwischen dem Dichtkörper und der äußeren Datenleitung als auch zwischen dem Dichtkörper und dem Gehäuse eine hohe Dichtigkeit zu erzielen. Geeignete Dichtkörper 36 sind in Figuren 8A bis 8C dargestellt, wobei Figur 8C als Blindstück für nicht benötigte zweite Aussparungen vorgesehen ist. Die Ausführungsform nach Fig. 8A dient zum Durchführen von im Querschnitt runden Anschlussleitungen und die Ausführung nach Fig. 8B zum Durchführen von so genannten Flachkabeln. Alle Dichtkörper weisen in Ihrer unteren Hälfte eine Abflachung auf, die der Gehäuseausnehmung entspricht, auf, um ein Verdrehen zu verhindern. Ein Schlitz 36A gestattet das Anheben oder seitliche Verdrehen des oberen Teils des Dichtungskörpers wenn dieser in das Gehäuse schon eingesetzt ist, um eine äußere Datenleitung in die Durchgangsdurchbrechung 36B einzulegen. Randabschrägungen in der oberen Dichtkörperhälfte dienen als Führungselemente 36C, 36D und gestatten das Schließen des bewegbaren Deckels 30 auch bei einer Vielzahl von nebeneinander angeordneten Dichtkörpern (mit oder ohne eingelegten äußeren Datenleitungen).

Um der gewissen Steifigkeit der Datenleitungen gerecht zu werden, ohne die Anschlussverbindungen mechanisch zu gefährden, sind Kabelführungen 38A, 38B an dem bewegbaren Deckel 30 in Ergänzung zu den Teilaussparungen 32A, 32B vorgesehen. Die Kabelführungen 38A sind keilförmig ausgebildet, um eine Zentrierung beim Deckelschließen zu ermöglichen. Zusätzlich sind richtungsgebende Elemente 39 in Gestalt von gebogenen Federn vorgesehen, die die äußeren Datenleitungen an den Kabelführungen 38B festklemmen und beim Deckelschließen gegen unbeabsichtigtes Öffnen durch Rückhalteelemente 39A gesichert sind.

Seitliche und miteinander korrespondierende Schrägauflagen 20C und 20D am Gehäuse 20 und am bewegbaren Deckel 30 erleichtern die Handhabung des Deckels und der Datenanschlussleitungen beim Anschluss das Schaltermodul.

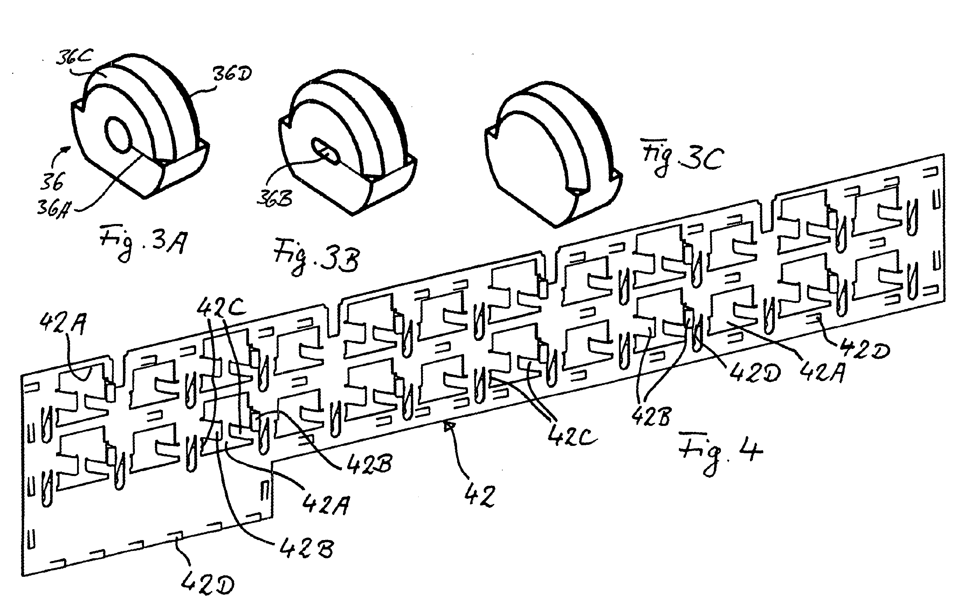

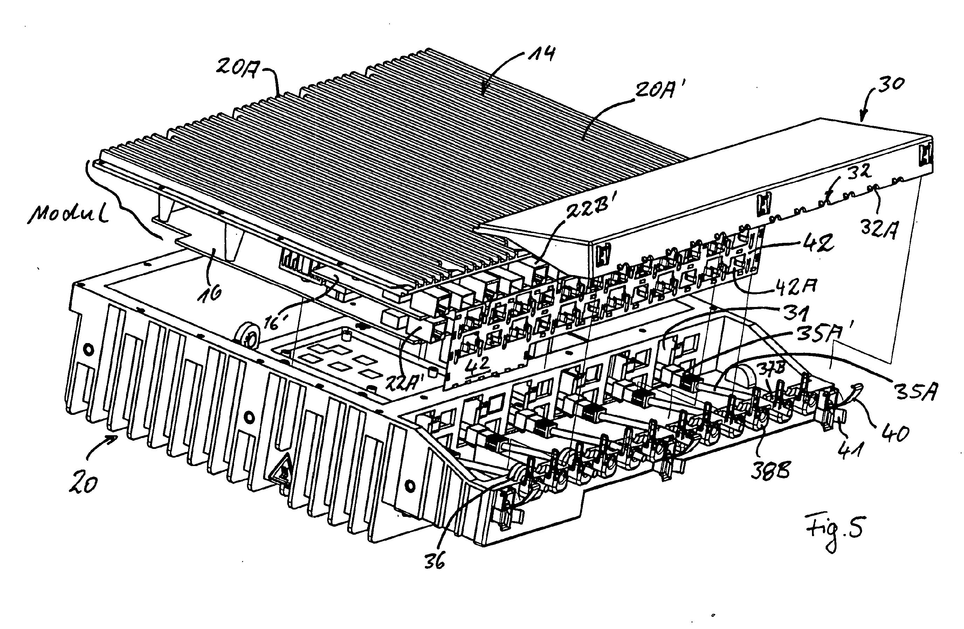

Aus Figuren 4 und 5 ist ferner ein Strahlungsschutzorgan 42 ersichtlich, dass aus einem komplex gebogenen Federstahlblech mit Durchbrüchen 42A besteht, die den gewünschten Positionen und den Größen von standardisierten Steckverbindungen entsprechen. Beidseitig umfasst dieses Strahlungsschutzblech Rastelemente 42B und 42C, die einerseits mit der Platinenseite und andererseits mit der inneren Frontpanel-Rückseite verrastbar sind. Integrierte Andruckfedem 42D unterstützen die Positionierung und Abstandshaltung zur Frontpanel-Rückseite hin. Die im inneren Frontpanel 20B' vorgesehenen ersten Aussparungen 31 für Steckverbindungen können also- mit ausreichendem Spiel für die Kabelstecker ausgebildet sein, ohne den Strahlenschutz zu beeinträchtigen.

Eine Formschlussverriegelung 41 sichert die Deckelverriegelungselemente 40 in ihrer Schließposition vor unbeabsichtigtem Zurückfedern bei starken Vibrationen und Stößen.

Eine derartige Schalteranordnung ist also trotz einfacher Verbindbarkeit mit Datenanschlussleitungen unter Verwendung standardisierter Steckverbindungen einfach zu bestücken und im Gebrauch in rauer Umgebungsatmosphäre sicher einsetzbar.

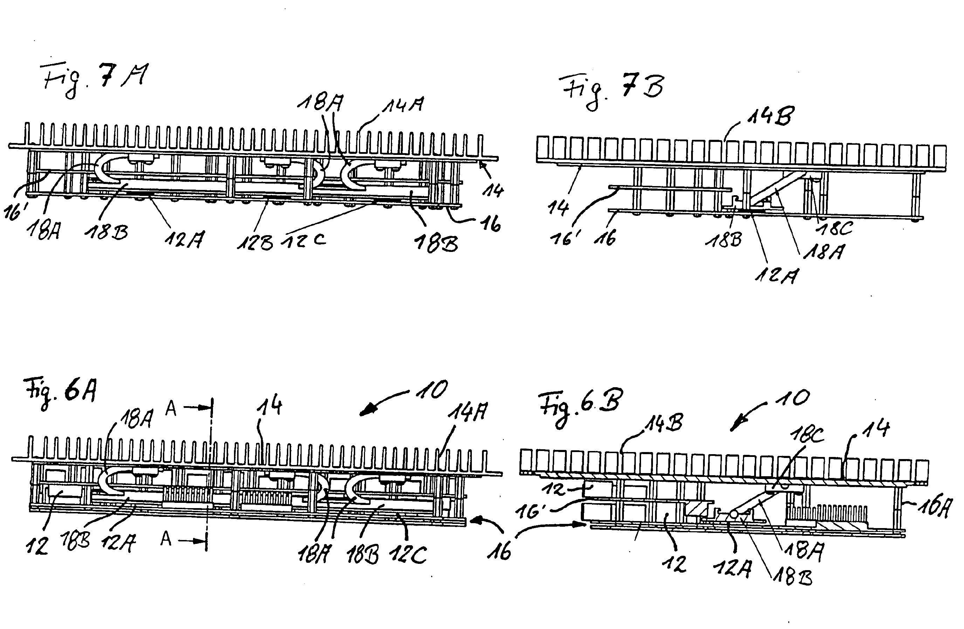

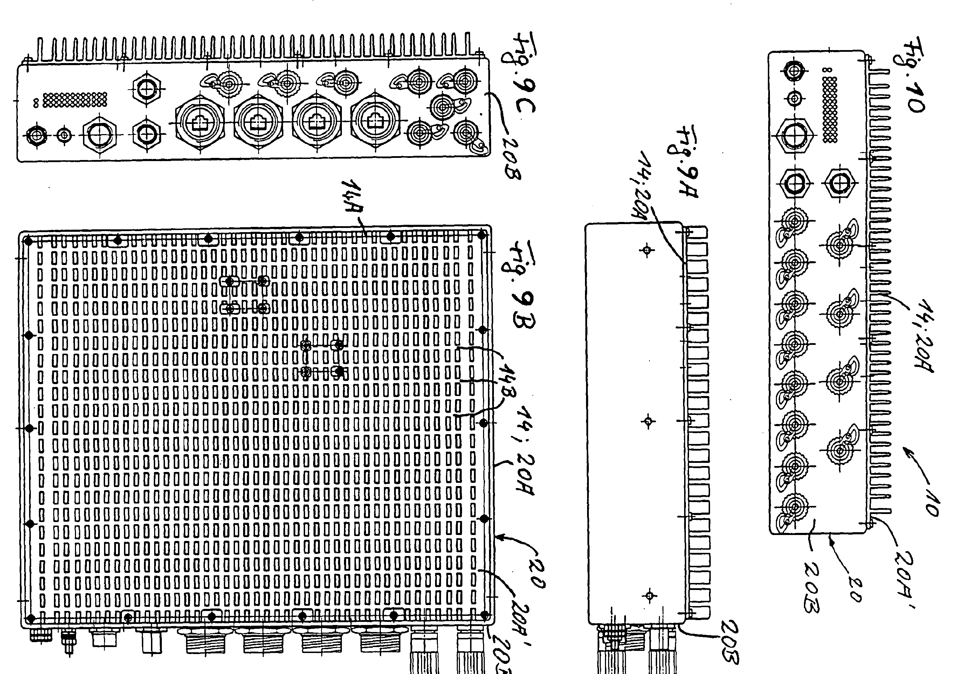

Aus Figuren 6A/B ist eine Schalteranordnung 10 ersichtlich, wie sie in den Ausführungsbeispielen nach Figuren 9A-4C verbaut ist oder nach Figuren 1A bis . Die in der Zeichnung obere Seite besteht aus einem rechteckigen, die gesamte Gerätefläche in Anspruch nehmenden Rippenkühler 14 aus einem stranggegossen Leichtmetallprofil. Dessen zueinander und zu einer Gerätekante parallel verlaufenden rechtwinklig abstehenden Kühlrippen 14A sind in einer dazu rechtwinklig verlaufenden Richtung von paralielen Reihen von Ausnehmungen 14B unterbrochen, die zum Beispiel durch Fräsen erzeugt werden können. Eine Platine 16 weist einen lediglich um eine Randzone schmaleren Grundriss als der Rippenkühler 14 auf und ist über übliche Gewindehülsen 16A starr und mit festem paralllem Abstand mit dem Rippenkühler 14 verbunden. Die Platine 16 ist mit einer Vielzahl von elektronischen Bauteilen 12 bestückt, unter anderem mit Prozessoren 12A, B, C, zum Schalten von Kommunikations-Datenströmen, welche allesamt auf der zum Rippenkühler 14 hin gewandten Seite der Platine 16 sich in dem zwischen Platine und Rippenkühler gebildeten Hohlraum befinden. Eine weitere Platine 16' befindet sich auf einem Zwischenniveau zwischen Platine 16 und dem Rippenkühler 14 zur Aufnahme weiterer Schaltkreise beziehungsweise elektronischer Bauteile 12. Sie nimmt eine geringere Grundfläche als die Platine 16 in Anspruch.

Die drei Prozessoren 12A, B, C sind mittels eines Wärmeausgleichselementes 18B in Gestalt eines länglichen Alluminiumprofils wärmeleitend körperlich miteinander verbunden - gegebenenfalls unter Zwischenfügung einer Wärmeleitpaste. Von dem länglichen Wärmeausgleichselement 18B wird die Wärme der Prozessoren über mehrere Wärmeableiter 18A in Gestalt so genannter Heatpipes zum Rippenkühler 14 abgeführt. Bei den Heatpipes handelt es sich um gebogene Rohre aus wärmeleitendem Material, die mit einer Flüssigkeit gefüllt sind und etwa U-förmig mit einem halbkreisigen Bogen geformt sind, sodass sie sich auf den exakten Abstand zwischen den wärmeleitend zu verbindenden Bauteilen einstellen lassen. Aus Figur 7A/B geht die Kühlanordnung besonders deutlich hervor. Der Übersichtlichkeit halber sind auch die Prozessoren auf einer Platine sitzend dargestellt. Im Übrigen ist aus Figuren 6A/B ersichtlich, dass die Schaltanordnung beidseitig großflächig geschützt ist, nämlich auf der Oberseite durch den Rippenkühler 14 und auf der Unterseite durch die nicht durch Bauteile bestückte Fläche der Platine 16.

Wie sich aus Figuren 8A bis 8C ergibt, ist die Platine in besonderer Weise mechanisch geschützt indem sie - so wie die Schalteranordnung als Ganze - einen Sandwichaufbau aufweist:

Patchfeldartig angeordnete doppelseitige Klebestreifen (zweite Verstärkungselemente 24B) dienen als Distanzhalter und Haftvermittler zu einem mit der Platine etwa gleich großen ersten Verstärkungselement 24A, zum Beispiel einer Karbonfaserplatte. Dadurch ist ein nach Außen glatter Abschluss der Schaltanordnung verwirklicht. Die Karbonfaserplatte weist im vorliegenden Fall Aussparungen 26 auf, um zum Beispiel Potentiometer oder dergleichen von Außen zugänglich zu machen oder beziehungsweise Raum für tiefer im Gehäuse 20 (Figuren 9A-9C) zu schaffen. Über Ein- und Ausgangsanschlüsse 22A/B kann die Schalteranordnung gelegene Bauteile über Verbindungskabel (nicht dargestellt) mit dem Datenverbindungsanschlüssen auf einem Front-Paneel des Gehäuses 20 verbunden werden. Wie im Übrigen aus Figur 8A ersichtlich bildet die Schalteranordnung 10 ein Gehäuseteil 20A - im vorliegenden Fall einen Gehäusedeckel, der in geeigneter Weise durch Schrauben und/oder Verschwenken geöffnet werden kann, wobei der Rippenkühler 14 die entsprechende Gehäuseteil-Außenfläche 20A' bildet.

Das Gehäuse 20 als Ganzes ergibt sich in drei Ansichten in Figuren 9A bis 9C. Figur 10 zeigt eine zu Figur 9C alternative Frontplattengestaltung für Anwendungsfälle, die andere Anschlussverbindungen benötigen.

### BEZUGSZEICHENLISTE

- 10: Schalteranordnung
- 12: el. Bauteile
- 12A, B, C: Prozessor
- 14: Rippenkühler
- 14A: Kühlrippe
- 14B: Ausnehmungen
- 16: Platine
- 16': weitere Platine
- 16A: Gewindehülsen
- 18A: Wärmeableiter
- 18B: Wärmeausgleichselement
- 18C: Klemmstück für 18A
- 20: Gehäuse
- 20': Gehäuse-Frontteil
- 20A: Gehäuseteil
- 20A': Gehäuseteil-Außenfläche
- 20B: Frontpanel
- 20 B': inneres Frontpanel
- 20 B": äußeres Frontpanel
- 20 C: Schrägauflage
- 20D: Schrägauflage
- 22A/B: Ein- und Ausgangsanschlüsse
- 22A'/B': Ein- und Ausgangsanschlüsse
- 24A: erstes Verstärkungselement
- 24B: zweites Verstärkungselement
- 26: Aussparung
- 30: bewegbarer Deckel
- 30': Deckel-Frontteil
- 31: erste Aussparungen
- 32: zweite Aussparungen

- 32A/B: Teil-Aussparungen
- 33: Verschließkörper
- 33A-D: Verschließkörperhälfte
- 33A' - 33D': Verschließkörperhälfte
- 34A: Durchführung für äußere Da- tenleitung
- 34B: Durchführung für äußere Da- tenleitung
- 35A: äußere Datenleitung
- 35A': Stecker
- 35B: äußere Datenleitung
- 35B': Stecker
- 36: Dichtkörper
- 36A: Schlitz
- 36B: Durchbrüche
- 36C: Führungselement
- 36D: Führungselement
- 37A/B: Dichtkörperaufnahmen
- 38A/B: Kabelführungen
- 39: Kabelführungs- oder richtungs- gebungselemente
- 39A: Rückhalteelement
- 40: Deckelverriegelungselement
- 41: Formschlussverriegelungsele- ment
- 42: Strahlungsschutzorgan
- 42A: Durchbrüche
- 42B: Rastelemente
- 42C: Rastelemente
- 42D: Andruckfedern

## Patentansprüche

1. Schalteranordnung für Kommunika.tions-Datenströme
mit mindestens einem Prozessor (12A, 12B) für die Annahme und das Weiterleiten von Daten bzw. Datenströmen,
mit mindestens einem Kühler zum Kühlen des mindestens einen Prozessors,
mit mindestens einer Platine (16) zur Aufnahme des mindestens einen Prozessors und gegebenenfalls weiterer elektronischer Bauelemente der Schalteranordnung (10) sowie zur direkten oder indirekten Aufnahme von Ein- und Ausgangsanschlüssen (22A, 22B) für Datenempfang und/oder Datenversendung über äußere Datenleitungen (35A, 35B), und
mit einem Gehäuseteil (20A) zur Aufnahme der Platine (16),
**dadurch gekennzeichnet,**
**dass** die äußeren Datenleitungen (35A, 35B) an, vorzugsweise für Innenräume vorgesehene, EDV-Ein- und Ausgangsanschlüsse (22A', 228') der Platine (16, 16') anschließbar sind und die Gehäusefront (22B) ein inneres, die Platine (16) abdeckendes Frontpanel (20B') und ein äußeres Frontpanel (20B") umfasst, wobei das innere Frontpanel (20B') Aussparungen (31) für die Anordnung der Einund Ausgangsanschlüsse (22A', 22B') an, in oder hinter dem inneren Frontpanel (20B') aufweist.

2. Schalteranordnung nach Anspruche 1 , **dadurch gekennzeichnet, dass** das äußere Frontpanel (20B") auf die Querschnitte der äußeren Datenleitungen reduzierbare oder reduzierte zweite Aussparungen (32) aufweist.

3. Schalteranordnung nach Anspruch 1 oder 2, **dadurch gekennzeichnet, dass** die zweiten Aussparungen (32) aus paarweisen Teilaussparungen (32A, 32B) bestehen.

4. Schalteranordnung nach Anspruch 2 oder 3 **gekennzeichnet durch** in die zweiten Aussparungen (32) eingesetzte oder einsetzbare Verschließ- und/oder Dichtkörper (33, 33', 33A, 33B, 33C, 33D, 33E; 36).

5. Schalteranordnung nach einem der Ansprüche 1 bis 4, **dadurch gekennzeichnet, dass** elastische Dichtkörper (36) in das äußere Frontpanel (20B") zur nachträglichen Aufnahme von äußeren Datenleitungen (35A, 35B) eingesetzt sind.

6. Schalteranordnung nach Anspruch 5, **dadurch gekennzeichnet, dass** die Dichtkörper (36) unverdrehbar in Aufnahmen (37A, 37B) des äußeren Frontpanels (20B") ruhen.

7. Schalteranordnung nach Anspruch 5 oder 6, **dadurch gekennzeichnet, dass** die Dichtkörper (36) zumindest ein Führungselement (36C, 36D) zum gleichzeitigen Aufschieben eines Deckel-Frontteils (30') und/oder auf sämtliche Dichtkörper (36) im äußeren Frontpanel (20B") aufweist.

8. Schalteranordnung nach einem der Ansprüche 1 bis 7, **dadurch gekennzeichnet, dass** das äußere Frontpanel (22B") aus einem mit dem Gehäuse fest verbundenen Gehäuse-Frontteil (20') und einem bewegbaren Deckel-Frontteil (30') besteht.

9. Schalteranordnung nach Anspruch 8, **dadurch gekennzeichnet, dass** das Gehäuse-Frontteil (20') und das Deckel-Frontteil (30') einander ergänzende innere und/oder äußere Kabelführungen (38A, 38B) aufweisen.

10. Schalteranordnung nach einem der Ansprüche 1 bis 9, **dadurch gekennzeichnet, dass** Zugentlastungen und/oder Richtungsgebungselemente (39) für die äuβeren Datenleitungen an der Vorder- und/oder Hinterseite des äußeren Frontpanels (22B"), vorzugsweise unter einem Deckel (30), angeordnet sind.

11. Schalteranordnung nach einem der Ansprüche 8 bis 10, **dadurch gekennzeichnet, dass** das Deckelfrontteil (30') nach leichten Verschwenken fortnehmbar ist.

12. Schalteranordnung nach einem der Ansprüche 8 bis 11, **dadurch gekennzeichnet, dass** das Deckelfrontteil (30') gegenüber dem Gehäuse (20) über seitliche Schrägauflagen (20C, 20D) in seiner Randzone verfügt.

13. Schalteranordnung nach dem Oberbegriff von Anspruch 1, insbesondere nach einem der Ansprüche 1 bis 13, **gekennzeichnet durch** ein Strahlungsschutzorgan (42) zum Abschirmen elektromagnetischer und ähnlicher Strahlungen von der Schalteranordnung nach Außen oder in die Schalteranordnung, bestehend aus einem mit Durchbrüchen (42A) zur Verbindungsherstellung mit Ein- und Ausgangsanschlüssen versehenes Flächenelement mit beidseitig daran vorgesehenen Rastelementen zum Verbinden des Strahlungsschutzorgans mit mindestens einer Stirnseite der mindestens einen Platine (16) einerseits und mit einem Frontpanel, insbesondere dem inneren Frontpanel (22B') andererseits.

14. Schalteranordnung nach einem der Ansprüche 1 bis 13, **dadurch gekennzeichnet, dass** der Kühler als Rippenkühler (14) auf einer Gehäuseteil-Außenfläche (20A') vorgesehen ist oder diese bildet und mittelt mindestens eines Wärmeableiters (18A) im Gehäuseinneren mit dem mindestens einen Prozessor (12A, 12B, 12C) körperlich wärmeleitend kontaktiert ist.

15. Schalteranordnung nach Anspruch 14, **dadurch gekennzeichnet, dass** der Rippenkühler die Gehäuseteil-Außenfläche (20A') i.w. vollständig einnimmt oder bildet.

16. Schalteranordnung nach Anspruch 14 oder 15 **dadurch gekennzeichnet, dass** der Rippenkühler mit Abstand voneinander angeordneten Ausnehmungen, (14B) quer zu den Kühlrippen (14A) aufweist.

17. Schalteranordnung nach einem der Ansprüche 14 bis 16, **dadurch gekennzeichnet, dass** der Rippenkühler (14) und die mindestens eine Platine (16) mit Abstand voneinander fest verbunden sind, insbesondere das Deckelteil eines Gehäuses der Schalteranordnung bilden.

18. Schalteranordnung nach einem der Ansprüche 14 bis 17, **dadurch gekennzeichnet, dass** mehrere Prozessoren (12A, 12B, 12C) mit einem Wärmeausgleichselement (18B) wärmeleitend verbunden sind und das Wärmeausgleichselement mittels des mindestens einen Wärmeableiters (18A) mit dem Rippenkühler (14) körperlich wärmeleitend verbunden ist.

19. Schalteranordnung nach dem Oberbegriff von Anspruch 1, insbesondere nach einem der Ansprüche 1 bis 18, **dadurch gekennzeichnet, dass** die mindestens eine Platine (16) auf ihrer von dem mindestens einem Prozessor (12A, 12B, 12C) abgewandten Seite mittels Verstärkungselementen (24A, 24B) als Sandwich-Anordnung ausgebildet ist.

20. Schalteranordnung nach Anspruch 19, **dadurch gekennzeichnet, dass** ein der Platine (16) in der Sandwich-Anordnung gegenüberliegendes (erstes) Verstärkungselement (24A) mindestens eine Aussparung zur Aufnahme elektrischer oder elektronischer Bauteile der Schalteranordnung aufweist.

21. Schalteranordnung nach Anspruch 19 oder 20 **dadurch gekennzeichnet, dass** ein Verstärkungselement (24B) aus einem Patch-Feld von flächigen, Distanz haltenden Verbindungselementen, wie doppelseitigen Klebestreifen besteht.

22. Schalteranordnung nach dem Oberbegriff von Anspruch 1, insbesondere nach einem der Ansprüche 1 biss 21, **dadurch gekennzeichnet, dass** ein Gehäusedeckel (20A) und die mindestens eine Platine (16) ein einzeln handhabbares Schaltermodul bilden, bei dem der Kühler als Rippenkühler (14) auf einer Modul-Außenfläche (20A') vorgesehen ist und mittels mindestens eines Wärmeableiters (18A) mit dem mindestens einen Prozessor (12A, 12B, 12C) körperlich wärmeleitend kontaktiert ist, wobei der Rippenkühler eine erste und die Platine eine, mit dem Rippenkühler mit Abstand fest verbundene zweite Modul-Außenfläche bilden.

23. Schalteranordnung nach Anspruch 22, **dadurch gekennzeichnet, dass** ein Wärmeausgleichselement (18B) in körperlich wärmeleitender Verbindung mit mehreren mit Abstand voneinander angeordneten Prozessoren verbunden ist.

24. Schalteranordnung nach Anspruch 22 oder 23 **gekennzeichnet durch** mindestens eines der Merkmale der Ansprüche 14 bis 21.

## Claims

1. A switch arrangement for communication data streams comprising:
at least one processor (12A, 12B) for receiving and forwarding data or data streams,
at least one cooler for cooling the at least one processor,
at least one printed circuit board (16) for accommodating the at least one processor and possibly further electronic components of the switch arrangement (10) as well as for directly or indirectly accommodating input and output connections (22A, 22B) for data reception and/or data transmission via outer data lines (35A, 35B), and
a housing part (20A) for accommodating the printed circuit board (16),
**characterised in that**
the outer data lines (35A, 35B) are connectable to EDP input and output connections (22A', 22B') of the printed circuit board (16, 16') preferably provided for indoors, and the housing front (22B) comprises an inner front panel (20B') covering the printed circuit board (16) and an outer front panel (20B"), wherein the inner front panel (20B') comprises recesses (31) for arranging the input and output connections (22A', 22B') in or behind the inner front panel (20B').

2. Switch arrangement according to claim 1, **characterised in that** the outer front panel (20B") comprises second recesses (32) reducible or reduced to the cross-sections of the outer data lines.

3. Switch arrangement according to claim 1 or 2, **characterised in that** the second recesses (32) consist of pairs of partial recesses (32A, 32B).

4. Switch arrangement according to claim 2 or 3, **characterised by** closing and/or sealing bodies (33, 33' 33A, 33B, 33C, 33D, 33E; 36) inserted or insertable into the second recesses (32).

5. Switch arrangement according to one of claims 1 to 4, **characterised in that** elastic sealing bodies (36) are inserted into the outer front panel (20B") for the subsequent accommodation of outer data lines (35A, 35B) .

6. Switch arrangement according to claim 5, **characterised in that** the sealing bodies (36) rest in a non-rotatable manner in holders (37A, 37B) of the outer front panel (20B").

7. Switch arrangement according to claim 5 or 6, **characterised in that** the sealing bodies (36) comprise at least one guide element (36C, 36D) for simultaneously pushing a cover front part (30') onto one and/or all sealing bodies (36) in the outer front panel (20B") .

8. Switch arrangement according to one of claims 1 to 7, **characterised in that** the outer front panel (20B") consists of a housing front part (20') firmly connected with the housing and a movable cover front part (30').

9. Switch arrangement according to claim 8, **characterised in that** the housing front part (20') and the cover front part (30') comprise inner and/or outer cable ducts (38A, 38B) which complement each other.

10. Switch arrangement according to one of claims 1 to 9, **characterised in that** strain relief's and/or direction-setting elements (39) for the outer data lines are arranged on the front side and/or the rear side of the outer front panel (20B"), preferably behind a cover (30).

11. Switch arrangement according to one of claims 8 to 10, **characterised in that** the cover front part (30') can be removed by pivoting it lightly.

12. Switch arrangement according to one of claims 8 to 11, **characterised in that** the cover front part (30'), relative to the housing (20), has lateral oblique supporting surfaces (20C, 20D) in its edge zone.

13. Switch arrangement according to the preamble of claim 1, in particular according to one of claims 1 to 13, **characterised by** a radiation protection element (42) for preventing electro-magnetic and similar types of radiation from the switch arrangement from reaching the outside or the inside of the switch arrangement, consisting of an areal element provided with cut-outs (42A) for establishing the connections with input and output connections and including locking elements provided on both sides for connecting the radiation protection element to at least one face of the at least one printed circuit board (16) on the one hand and with a front panel, in particular an inner front panel (22B'), on the other.

14. Switch arrangement according to one of claims 1 to 13, **characterised in that** the cooler is a fin cooler (14) provided on a housing part external surface (20A') or forming the same and is contacted, inside the housing, via at least one heat dissipater (18A) in a physically heat-conducting manner with the at least one processor (12A, 12B, 12C).

15. Switch arrangement according to claim 14, **characterised in that** further the fin cooler completely occupies the housing part external surface (20A') or forms the same.

16. Switch arrangement according to claim 14 or 15, **characterised in that** the fin cooler comprises spaced-apart recesses (14B) extending transversely to the cooling fins (14A).

17. Switch arrangement according to one of claims 14 to 16, **characterised in that** the fin cooler (14) and the at least one printed circuit board (16) are firmly connected with one another but spaced apart, forming, in particular, the cover part of a housing of the switch arrangement.

18. Switch arrangement according to one of claims 14 to 17, **characterised in that** several processors (12A, 12B, 12C) are connected with a heat equalisation element (18B) in a heat-conducting manner and the heat equalisation element (18B) is connected with the fin cooler (14) in a physically heat-conducting manner by means of the at least one heat dissipater (18A).

19. Switch arrangement according to the preamble of claim 1, in particular according to claims 1 to 18, **characterised in that** the at least one printed circuit board (16), on the side facing away from the at least one processor (12A, 12B, 12C), is formed as a sandwich arrangement by means of reinforcing elements (24A, 24B).

20. Switch arrangement according to claim 19, **characterised in that** a (first) reinforcing element (24A) opposite the printed circuit board (16) in the sandwich arrangement comprises at least one recess for accommodating electrical or electronic components of the switch arrangement.

21. Switch arrangement according to claim 19 or 20, **characterised in that** a reinforcing element (24B) consists of a patch field of areal distance-maintaining connecting elements such as double-sided adhesive strips.

22. Switch arrangement according to the preamble of claim 1, in particular according to one of claims 1 to 21, **characterised in that** a housing cover (20A) and the at least one printed circuit board (16) form a singly manageable switch module, where the cooler is a fin cooler (14) provided on a module external surface (20A') and is contacted via at least one heat dissipater (18A) with the at least one processor (12A, 12B, 12C) in a physically heat-conducting manner, wherein the fin cooler forms a first and the printed circuit board forms a second module outer surface firmly connected with, but spaced apart from, the fin cooler.

23. Switch arrangement according to claim 22, **characterised in that** a heat equalisation element (18B) is connected with several spaced-apart processors so as to form a physically heat-conducting connection.

24. Switch arrangement according to claim 22 or 23, **characterised by** at least one of the features of claims 14 to 21.

## Revendications

1. Commutateur pour des flux de données de communication comprenant :
- au moins un processeur (12A, 12B) pour recevoir et transmettre des données ou des flux de données,
- au moins un radiateur pour refroidir au moins un processeur,
- au moins une platine (16) pour recevoir au moins un processeur et le cas échéant d'autres composants électroniques du montage de commutateur (10), ainsi que pour recevoir directement ou indirectement des branchements d'entrée et de sortie (22A, 22B) pour la réception de données et/ou l'émission de données par des lignes de transmission de données extérieures (35A, 35B), et
- une partie de boîtier (20A) pour recevoir la platine (16), commutateur **caractérisé en ce que**
les lignes de données extérieures (35A, 35B) sont reliées de préférence à des branchements d'entrée et de sortie de traitement de données (22A', 22B') prévus de préférence pour des volumes intérieurs et la façade du boîtier (22B) a un panneau frontal intérieur (20B') couvrant la platine (16, 16') et un panneau frontal extérieur (20B"),
le panneau frontal intérieur (20B') comportant des dégagements (31) pour monter des branchements d'entrée et de sortie de traitement électronique de données (22A', 22B') dans ou derrière le panneau frontal intérieur (20B').

2. Commutateur selon la revendication 1,
**caractérisé en ce que**
le panneau frontal extérieur (20B") comporte des seconds dégagements (32) qui peuvent être réduits ou sont réduits à la section des lignes de transmission de données extérieures.

3. Commutateur selon la revendication 1 ou 2,
**caractérisé en ce que**
les seconds dégagements (32) se composent de dégagements partiels (32A, 32B) prévus par paires.

4. Commutateur selon la revendication 2 ou 3,
**caractérisé par**
des organes de fermeture et/ou d'étanchéité (33, 33', 33A, 33B, 33C, 33D, 33E, 36) placés ou susceptibles d'être placés dans les seconds dégagements (32).

5. Commutateur selon l'une des revendications 1 à 4,
**caractérisé en ce que**
des organes d'étanchéité (36), élastiques, sont placés dans le panneau frontal extérieur (20B") pour recevoir ensuite des lignes extérieures de transmission de données (35A, 35B).

6. Commutateur selon la revendication 5,
**caractérisé en ce que**
les organes d'étanchéité (36) sont logés de manière bloquée en rotation dans des logements (37A, 37B) du panneau frontal extérieur (20B").

7. Commutateur selon la revendication 5 ou 6,
**caractérisé en ce que**
les organes d'étanchéité (36) comportent au moins un élément de guidage (36C, 36D) pour engager simultanément une pièce frontale de couvercle (30') et/ou tous les organes d'étanchéité (36) dans le panneau frontal extérieur (20B").

8. Commutateur selon l'une des revendications 1 à 7,
**caractérisé en ce que**
le panneau frontal extérieur (20B") se compose d'une pièce frontale de boîtier (20') reliée solidairement au boîtier et d'une pièce frontale de couvercle (30') mobile.

9. Commutateur selon la revendication 8,
**caractérisé en ce que**
la pièce frontale de boîtier (20') et la pièce frontale de couvercle (30') comportent des guides-câbles (38A, 38B) intérieurs et/ou extérieurs qui se complètent.

10. Commutateur selon l'une des revendications 1 à 9,
**caractérisé par**
des moyens de décharge en traction et/ou des éléments directionnels (39) sont prévus pour les lignes de données extérieures sur le côté avant et/ou le côté arrière du panneau frontal extérieur (20B"), de préférence sous un couvercle (30).

11. Commutateur selon l'une des revendications 8 à 10,
**caractérisé en ce que**
la partie frontale de couvercle (30') peut être dégagée par un léger basculement.

12. Commutateur selon l'une des revendications 8 à 11,
**caractérisé en ce que**
la partie frontale de couvercle (30') dispose en regard du boîtier (20), des surfaces d'appui inclinées (20C, 20D) dans la zone de son bord.

13. Commutateur selon le préambule de la revendication 1, notamment selon l'une des revendications 1 à 12,
**caractérisé par**
un organe de protection contre le rayonnement (42) pour couper le rayonnement électromagnétique ou autre rayonnement du commutateur vers l'extérieur ou dans le commutateur, cet organe se composant d'un élément de surface muni de passages (42A) pour réaliser la liaison avec les branchement d'entrée et de sortie, et des deux côtés des éléments d'accrochage pour relier l'organe de protection contre le rayonnement à au moins une face frontale d'au moins une platine (16) d'un côté et avec un panneau frontal, notamment avec le panneau frontal intérieur (20B') de l'autre côté.

14. Commutateur selon l'une des revendications 1 à 13,
**caractérisé en ce que**
le radiateur est un radiateur à ailettes (14) sur la surface extérieure (20A') de la pièce du boîtier ou constitue celui-ci et il est mis en contact par au moins un conducteur de chaleur (18A) avec au moins un processeur (12A, 12B, 12C) à l'intérieur du boîtier pour une conduction thermique par la matière.

15. Commutateur selon la revendication 14,
**caractérisé en ce que**
le radiateur à ailettes occupe ou constitue pratiquement complètement la surface extérieure (20A') de la pièce de boîtier.

16. Commutateur selon la revendication 14 ou 15,
**caractérisé en ce que**
le radiateur à ailettes comporte des cavités (14B) écartées les unes des autres et dirigées transversalement aux ailettes de refroidissement (14A).

17. Commutateur selon l'une des revendications 14 à 16,
**caractérisé en ce que**
le radiateur à ailettes (14) et au moins une platine (16) sont reliés solidairement l'un à l'autre à distance et forment notamment la pièce de couvercle d'un boîtier du commutateur.

18. Commutateur selon l'une des revendications 14 à 17,
**caractérisé en ce que**
plusieurs processeurs (12A, 12B, 12C) sont reliés à un élément d'équilibrage thermique (18B) par une liaison de conduction thermique et l'élément d'équilibrage thermique, est relié en conduction thermique par la matière par au moins un dispositif d'évacuation de chaleur (18A) avec le radiateur à ailettes (14).

19. Commutateur selon le préambule de la revendication 1, notamment selon l'une des revendications 1 à 18,
**caractérisé en ce qu'**
au moins une platine (16) est réalisée avec des éléments de renforcement (24A, 24B) suivant un montage en sandwich sur son côté non tourné vers au moins un processeur (12A, 12B, 12C).

20. Commutateur selon la revendication 19,
**caractérisé en ce qu'**
un (premier) élément de renforcement (24A) en regard de la platine (16) dans le montage en sandwich, comporte au moins un dégagement pour recevoir des composants électriques ou électroniques du commutateur.

21. Commutateur selon la revendication 19 ou 20,
**caractérisé en ce qu'**
un élément de renforcement (24B) se compose d'une zone de pastilles, d'éléments de liaison plats, conservant l'écartement, tels que des rubans adhésifs double-face.

22. Commutateur selon le préambule de la revendication 1, notamment selon l'une des revendications 1 à 21,
**caractérisé par**
un couvercle de boîtier (20A) et au moins une platine (16) forme un module de commutateur manipulable indépendamment, et dont le radiateur est un radiateur à ailettes (14) sur une surface extérieure (20A') du module et en contact de conduction thermique par la matière avec au moins un processeur (12A, 12B, 12C) par au moins un élément d'évacuation de chaleur (18A), le radiateur à ailettes formant une première surface extérieure du module et la platine, une seconde surface extérieure du module reliée solidairement et à distance au radiateur à ailette.

23. Commutateur selon la revendication 22,
**caractérisé en ce qu'**
un élément d'équilibrage de température (18B) est relié par une liaison de conduction thermique par la matière avec plusieurs processeurs distants les uns des autres.

24. Commutateur selon la revendication 22 ou 23,
**caractérisé en ce qu'**
il comporte au moins l'une des caractéristiques des revendications 14 à 21.
